(19) **Europäisches Patentamt**
**European Patent Office**
**Office européen des brevets**

(11) **EP 4 657 098 A1**

(12) **EUROPEAN PATENT APPLICATION**
published in accordance with Art. 153(4) EPC

(43) Date of publication:
**03.12.2025 Bulletin 2025/49**

(21) Application number: **24900776.6**

(22) Date of filing: **07.08.2024**

(51) International Patent Classification (IPC):
*G01R 31/389* (2019.01)       *G01R 31/396* (2019.01)
*G01R 31/382* (2019.01)       *G01R 31/367* (2019.01)
*G01R 27/08* (2006.01)        *G01R 23/16* (2006.01)
*H01M 4/36* (2006.01)

(52) Cooperative Patent Classification (CPC):
**G01R 23/16; G01R 27/08; G01R 31/367;**
**G01R 31/382; G01R 31/389; G01R 31/396;**
**H01M 4/36;** Y02E 60/10

(86) International application number:
**PCT/KR2024/011719**

(87) International publication number:
**WO 2025/121587 (12.06.2025 Gazette 2025/24)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **08.12.2023 KR 20230177918**

(71) Applicant: **LG Energy Solution, Ltd.**
**Seoul 07335 (KR)**

(72) Inventors:
• **LEE, Eun Ju**
**Daejeon 34122 (KR)**

• **KYUNG, Wonshik**
**Daejeon 34122 (KR)**
• **KIM, Heejin**
**Daejeon 34122 (KR)**
• **SON, Kihyun**
**Daejeon 34122 (KR)**
• **LEE, Sangwoo**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **SERVER, AND METHOD FOR DIAGNOSING ACTIVE AREA OF BATTERY CELL**

(57)    Disclosed are a method for diagnosing, by a server, an active area of a battery cell including a mixed negative electrode in which a first component and a second component are mixed, and the server. This method comprises the steps of: acquiring impedance information of a target battery cell to be diagnosed, by performing electrochemical impedance spectroscopy on the battery cell; acquiring, on the basis of the impedance information, information about a change in impedance according to a frequency; and diagnosing an active area of the target battery cell on the basis of the information about the change in impedance.

FIG. 3

```
Start
  ↓
Acquire impedance information on battery cell by
performing electrochemical impedance
spectroscopy for subject battery cell that is subject
of inspection                                        — 310
  ↓
Acquire impedance change information according
to frequency based on impedance information       — 320
  ↓
Inspect active area of subject battery cell based on
impedance change information.                        — 330
  ↓
End
```

EP 4 657 098 A1

## Description

## Technical Field

The present disclosure relates to a method for inspecting an active area of a battery cell and a server performing the same.

## Background Art

When an anode of a battery cell is designed with mixture of an SiO component and a graphite component in designing the anode of the battery cell, energy density in the battery cell may be improved in comparison with a case in which the anode of the battery cell is manufactured with only the graphite component. However, when a depth of use is concentrated excessively on SiO in operation of the battery cell, durability of the battery cell may have a trouble. Various studies are currently conducted to determine under what circumstance and to what degree the SiO in the mixed anode has a reaction depth and to change the depth of use to be suitable for a battery operation plan.

One of various technologies in the related art used to analyze the battery cell is electrochemical impedance spectroscopy (EIS). The EIS is an analysis method of applying an alternating current voltage or an alternating current in various frequencies, calculating impedance based on an alternating current or alternating voltage measured as a result of the applying, and showing the impedance in a Nyquist plot and has been widely used in that the battery cell may be analyzed in a nondestructive manner.

One of technologies in the related art used to further easily analyze a result of the EIS is distribution of relaxation times (DRT). The DRT is widely used in that impedance data calculated as a result of the EIS may be converted into a distribution of relaxation times so that an equivalent circuit of a battery may be identified while preliminary knowledge for impedance of the battery is not required.

## Detailed Description of the Invention

## Technical Goals

Example embodiments in the present disclosure is to provide a method for inspecting an active area of a battery cell and a server performing the same. Specifically, example embodiments in the present disclosure is to provide a method of analyzing a resistance value of impedance according to a change in a state of charge value of the battery cell through an EIS analysis and quickly determining under what state of charge value of the battery cell a predetermined component included in a mixed anode is dominantly activated.

However, the goals to be achieved by example embodiments of the present disclosure are not limited to the objectives described above and other objects may be clearly understood from the following example embodiments.

## Technical solutions

According to an example embodiment, there is provided a method for inspecting an active area of a battery cell including a mixed anode in which a first component and a second component are mixed, the method performed in a server and including acquiring impedance information on the battery cell by performing electrochemical impedance spectroscopy for a subject battery cell that is a subject of inspection, acquiring impedance change information according to a frequency based on the impedance information, and inspecting an active area of the subject battery cell based on the impedance change information.

The acquiring of the impedance change information may include generating a graph showing a magnitude of impedance according to the frequency by performing distribution of relaxation times (DRT) for the impedance information, and the inspecting may include inspecting an active area of the mixed anode based on the graph.

The generating of the graph may include generating, according to a change in a state of charge (SoC) value of the subject battery cell, graphs showing the magnitude of the impedance according to the frequency, and the inspecting may include inspecting the active area of the subject battery cell based on a first resistance value of impedance in a first graph at a first state of charge value, a second resistance value of impedance in a second graph at a second state of charge value less than the first state of charge value, and a third resistance value of impedance in a third graph at a third state of charge value less than the second state of charge value.

The inspecting may include calculating a first ratio of the first resistance value to the second resistance value, calculating a second ratio of the second resistance value to the third resistance value, calculating a third ratio that is a ratio of the second ratio to the first ratio, and determining that an active area in which the first component of the mixed anode is dominant is a first state of charge when the third ratio is less than or equal to a predetermined threshold value.

The inspecting may include calculating a first ratio of the first resistance value to the second resistance value, calculating a second ratio of the second resistance value to the third resistance value, calculating a third ratio that is a ratio of the second ratio to the first ratio, and determining that an active area in which the second component of the mixed anode is dominant is a first state of charge, a second state of charge, and a third state of charge when the third ratio is less than a predetermined threshold value.

The first resistance value may be acquired based on a value obtained by integrating the first graph according to the frequency, the second resistance value may be acquired based on a value obtained by integrating the second graph according to the frequency, and the third resistance value may be acquired based on a value obtained by integrating the third graph according to the frequency.

The acquiring of the impedance change information according to the frequency may include acquiring the impedance change information according to the frequency by performing a Nyquist plot analysis for the impedance information, and the plot analysis may be performed for at least one section of frequency sections selected based on a user input or frequency sections randomly selected.

The first component may be an SiO component, and the second component may be a graphite component.

The acquiring may include acquiring impedance information on the subject battery cell by performing the electrochemical impedance spectroscopy for the subject battery cell at a predetermined temperature or more.

According to an example embodiment, there is also provided a sever including a memory configured to store an instruction, and a processor connected to the memory, and the processor is configured to acquire impedance information on the battery cell by performing electrochemical impedance spectroscopy for a subject battery cell that is a subject of inspection, acquire impedance change information according to a frequency based on the impedance information, and inspect an active area of the subject battery cell based on the impedance change information.

Additional aspects of example embodiments will be set forth in part in the description which follows and, in part, will be apparent from the description, or may be learned by practice of the disclosure.

**Effects of the Invention**

According to proposed example embodiments, one or more of the following effects may be expected.

According to example embodiments of the present disclosure, it is possible to acquire impedance information according to a frequency change based on a result of EIS and DRT for a subject battery cell including a mixed anode.

According to example embodiments of the present disclosure, it is possible to acquire the impedance information according to the frequency change based on a Nyquist plot analysis result based on impedance information on the subject battery cell.

According to example embodiments of the present disclosure, it is possible to acquire a battery state of charge value at which each component forming the mixed anode of the subject battery cell is dominantly activated and use the battery state of charge value to manufacture a battery cell with improved durability in consideration of a degradation speed in a process of charging and discharging the battery cell.

Effects of the present disclosure are not limited to those described above and other effects may be made apparent to those skilled in the art from the following description of the accompanying claims.

**Brief Description of Drawings**

FIG. 1 illustrates an interlocking relationship of a server inspecting an active area of a battery cell according to an example embodiment.
FIG. 2 is a diagram for describing electrochemical impedance spectroscopy (EIS).
FIG. 3 is a flowchart for describing a method for inspecting an active area of a battery cell according to an example embodiment.
FIGS. 4A and 4B illustrate an example of impedance information and distribution of relaxation times (DRT) information in which a DRT is calculated therefor.
FIG. 5 is a diagram for describing a DRT information analysis process in a method for inspecting an active area of a battery cell according to an example embodiment.
FIG. 6 is a diagram for describing a Nyquist plot analysis process in a method for inspecting an active area of a battery cell according to an example embodiment.
FIG. 7 is a block diagram illustrating a configuration of a server inspecting an active area of a battery cell according to an example embodiment.

**Mode for Carrying Out the Invention**

Terms used in the example embodiments are selected, as much as possible, from general terms that are widely used at present while taking into consideration the functions obtained in accordance with the present disclosure, but these terms may be replaced by other terms based on intentions of those skilled in the art, customs, emergence of new technologies, or the like. Also, in a particular case, terms that are arbitrarily selected by the applicant of the present disclosure may be used. In this case, the meanings of these terms may be described in corresponding description parts of the disclosure. Accordingly, it should be noted that the terms used herein should be construed based on practical meanings thereof and the whole content of this specification, rather than being simply construed based on names of the terms.

In the entire specification, when an element is referred to as "including" another element, the element should not be understood as excluding other elements so long as there is no special conflicting description, and the element may include at least one other element.

Throughout the specification, expression "at least one of a, b, and c" may include 'a only', 'b only', 'c only', 'a and b', 'a and c', 'b and c', or 'all of a, b, and c'.

In the present disclosure, a "terminal" may be implemented as a computer or a portable terminal capable of accessing a server or another apparatus through a network. The computer may include, for example, a laptop computer, a desktop computer, and a notebook equipped with a web browser. The portable apparatus may be a wireless communication device ensuring a portability and a mobility, and include any type of handheld wireless communication device, for example, a tablet PC, a smartphone, a communication-based apparatus such as international mobile telecommunication (IMT), code division multiple access (CDMA), W-code division multiple access (W-CDMA), and long term evolution (LTE).

In the following description, example embodiments of the present disclosure will be described in detail with reference to the accompanying drawings so that those skilled in the art can easily carry out the present disclosure. However, the present disclosure may be embodied in many different forms and is not limited to the example embodiments described herein.

Hereinafter, the example embodiments of the present disclosure will be described with reference to the accompanying drawings.

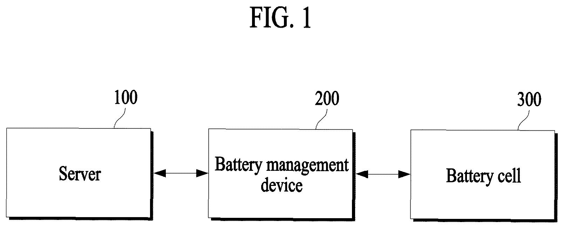

FIG. 1 illustrates an interlocking relationship of a server inspecting an active area of a battery cell according to an example embodiment.

Referring to FIG. 1, a system may be interlocked with a battery management device 200 managing a battery cell 300 and operate. In this case, the battery cell 300 may correspond to a subject battery cell including a mixed anode in which a first anode and a second anode are mixed. Meanwhile, only elements associated with the present example embodiment are illustrated in FIG. 1. Thus, those skilled in the art associated with the present example embodiment may understand that other elements in general use in addition to the elements illustrated in FIG. 1 may be further included.

A server 100 is a device that configures and provides a variety of information. The sever 100 may provide the configured information in a web page, an application screen, or the like or may provide the configured information in a form displayable in the web page, on an application screen, or the like in a received terminal.

The battery management device 200 may include one or more sensors for measuring a parameter such as an electric current, a voltage, or a temperature of the above-described battery cell 300 which includes the subject battery cell that is an inspection subject and may include a memory and a processor (not illustrated) for various operations. In other words, the above-described batter management device 200 may operate based on the memory and the processor similarly to the sever 100, but may additionally include a sensor to measure and calculate a parameter of the battery cell 300. According to an example embodiment, the battery management device 200 may apply an external alternating current power source, namely, an alternating current voltage or an alternating current to the battery cell 300 in various frequencies and measure an electric current or voltage flowing according thereto. Through this, the battery management device 200 may perform electrochemical impedance spectroscopy (EIS). In addition, the battery management device 200 may acquire a variety of impedance information on the battery cell 300 according to a frequency by constantly performing the EIS according to a change in a state of charge (SoC) value of the battery cell 300.

Here, the server 100 and the battery management device 200 each may be a completely separated and independent object. However, the server 100 and the battery management device 200 may be only conceptually separated to exist in one device or system. That is, one computing device having a control function for a battery cell may perform all functions of the server 100 and the battery management device 200 that will be described below, and accordingly, such an example embodiment is regarded as being included in the scope of the present disclosure.

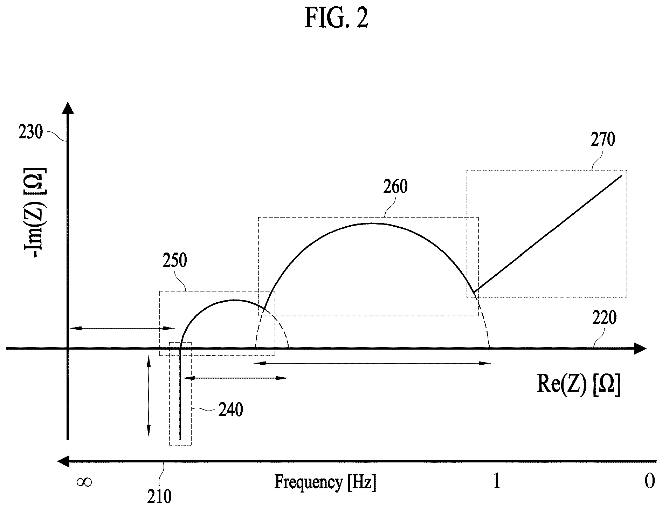

FIG. 2 is a diagram for describing electrochemical impedance spectroscopy (EIS).

Referring to FIG. 2, a concept of impedance spectroscopy used to acquire impedance information associated with a life of a battery cell may be identified. The impedance spectroscopy may be a method of interpreting a Nyquist plot acquired by dividing, by a real number component 220 and an imaginary number component 230, impedance information acquired by constantly changing a frequency 210 of an alternating current (AC) power source and applying the frequency 210 to a subject battery cell.

In the impedance spectroscopy, interpreting an electrochemical process of the Nyquist plot in association with an impedance analysis for the subject battery cell may be largely associated with analyzing four areas on the Nyquist plot. For example, an area 240 that is an intercept of an axis representing the real number component 220 of the impedance information may be used to analyze impedance information associated with a characteristic of electrolyte ion conductance of electrolyte resistance of the subject battery cell and a characteristics of external electrolyte resistance. For example, a first semicircle area 250 of the impedance information, which is acquired by changing a value of the frequency 210, may be used to analyze, in association with a solid electrolyte interphase (SEI), charge transfer impedance information in the SEI which is formed on an internal electrode particle surface/interface. Accordingly, information on a solid electrolyte interphase resistance (denoted by $R_{SEI}$)) of the subject battery cell may be acquired. For example, a second semicircle area 260 of the impedance information, which is acquired by changing the value of the frequency 210, may be used to analyze charge transfer impedance information showing a lithium-ion oxidation-reduction reaction on an electrode material interface by charge transfer resistance (denoted by $R_{CT}$) that is a phenomenon shown when a charge is moved on an electrode surface/interface of the subject battery cell. Accordingly, information on the charge transfer resistance of the subject battery cell may be acquired. For example, a linear area 270 acquired by changing the value of the frequency 210 may include Warburg impedance information acquired in a low-frequency area and may be used to analyze diffusion of an lithium ion (Li ion) associated with chemical diffusion resistance of the lithium ion by inter-layer insertion into a particle crystal structure in the subject battery cell.

The server 100 according to the present disclosure may inspect an active area, in which a component included in a mixed anode of a battery cell is dominantly activated, by using a graph acquired by performing distribution of relaxation times (DRT) for the impedance information acquired by constantly changing the value of the frequency 210, which is acquired as described above. Also, the server 100 may inspect the active area, in which the component included in the mixed anode of the battery cell is dominantly activated, by performing Nyquist plot analysis for the impedance information to analyze a difference between resistance values according to frequency values.

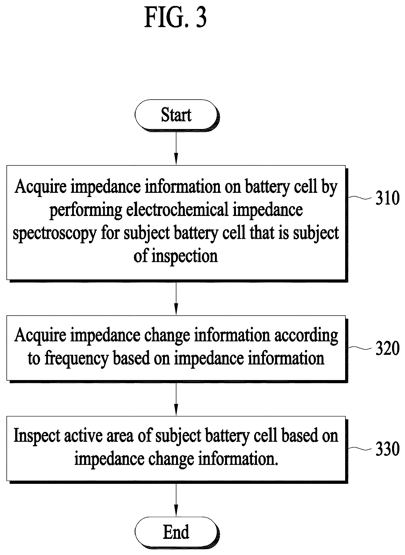

FIG. 3 is a flowchart for describing a method for inspecting an active area of a battery cell according to an example embodiment.

Referring to FIG. 3, in operation 310, the server 100 which performs the method for inspecting the active area of the battery cell according to an example embodiment may acquire impedance information on the battery cell by performing electrochemical impedance spectroscopy for a subject battery cell that is a subject of inspection. In this case, the server 100 may acquire information on the battery cell 300 from the battery management device 200. In this case, the battery cell may include a mixed anode in which a first component and a second component are mixed. For example, the first component may correspond to at least one of an SiO component, an SiC component, and an Si component, and the second component may correspond to a graphite component. The server 100 may acquire impedance information on the subject battery cell by performing the electrochemical impedance spectroscopy for the subject battery cell at a predetermined temperature or more. In the present disclosure, EIS analysis or EIS measurement may be a process of performing the electrochemical impedance spectroscopy for the battery cell, and EIS data or an EIS value may be information showing an impedance value according to a frequency for the battery cell.

In operation 320, the server 100 according to an example embodiment may acquire impedance change information according to the frequency based on the impedance information. The server 100 may acquire the impedance change information by generating a graph showing a magnitude of impedance according to the frequency by performing distribution of relaxation times (DRT) for the impedance information. In this case, the DRT may be a method for analyzing impedance information acquired through performance of the EIS and may be an analysis method of showing impedance magnitude information according to a frequency based on an assumption that each resistor-capacitor (RC) circuit corresponds to a predetermined frequency after an assumption that a large number of RC circuits are present in series without limiting a predetermined circuit model corresponding to the impedance information. That is, the graph showing the magnitude of the impedance in this case may correspond to a graph showing impedance magnitude information for each logarithmically scaled frequency. In the present disclosure, DRT analysis may be an analysis technique for identifying an impedance value according to each frequency for the EIS data, and a DRT analysis result or DRT information may be a graph showing an impedance magnitude for each frequency. Also, in operation S320, the server 100 according to an example embodiment may acquire the impedance change information according to the frequency by performing a Nyquist plot analysis for the impedance information, and the plot analysis may be performed for at least one section of frequency sections selected based on a user input or frequency sections randomly selected.

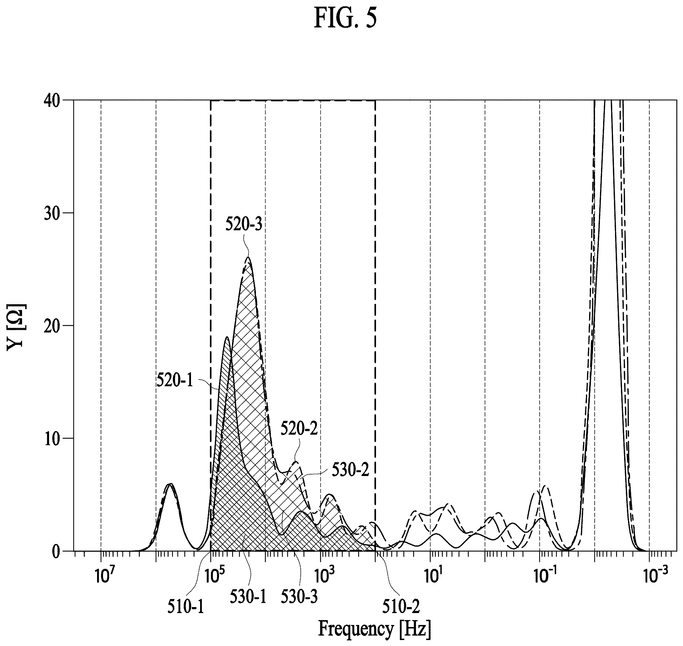

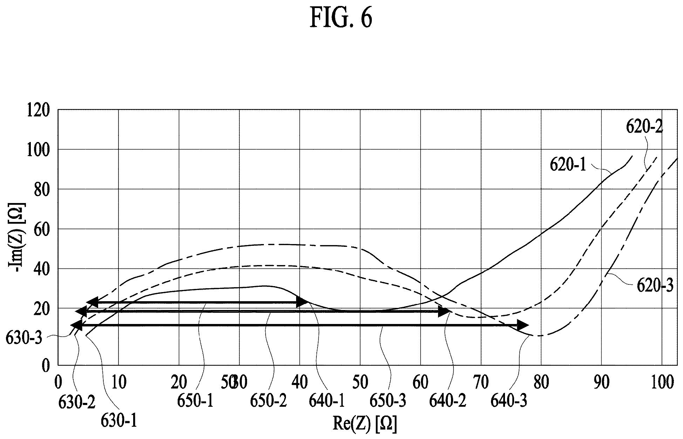

In operation 330, the server 100 according to an example embodiment may inspect an active area of the subject battery cell based on the impedance change information. The server 100 may generate the graph showing the magnitude of the impedance according to the frequency by performing the DRT for the impedance information in preceding operation 320 and may inspect the active area of the subject battery cell through inspecting an active area of the mixed anode based on the graph in operation 330. Details thereof will be described below in FIG. 5. In addition, the server 100 may acquire the impedance change information according to the frequency by performing the Nyquist plot analysis for the impedance information in preceding operation 320 and may inspect the active area of the subject battery cell through inspecting the active area of the mixed anode based on the impedance change information. Details thereof will be described below in FIG. 6.

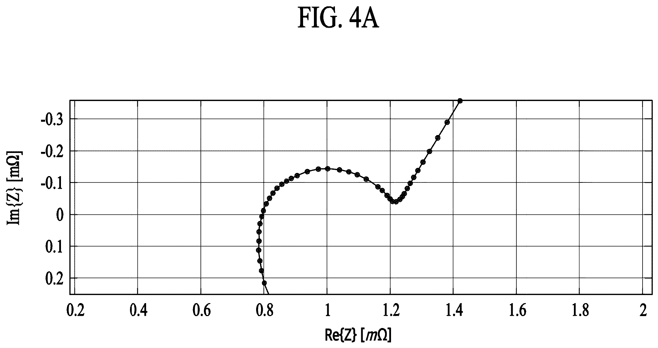

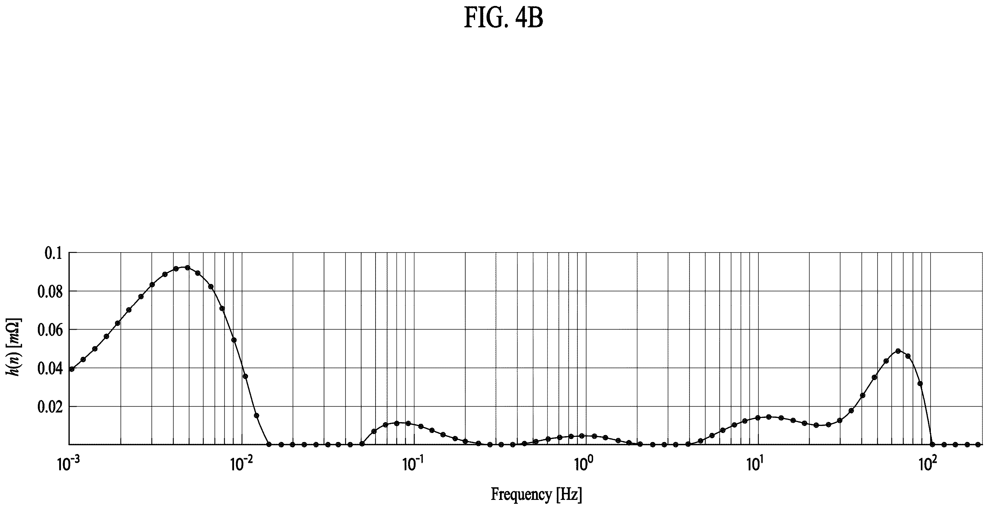

FIGS. 4A and 4B illustrate an example of impedance information and distribution of relaxation times (DRT) information in which a DRT is calculated therefor.

FIGS. 4A and 4B illustrate the example of the impedance information and the distribution of relaxation times (DRT) information in which the DRT is calculated therefor. Referring to FIG. 4A, when EIS is performed for a subject battery cell, the impedance information may be identified in a Nyquist plot in which a magnitude of impedance is divided and shown in a real part and an imaginary part for each frequency. In addition, when the DRT is calculated based on the Nyquist plot drawn as illustrated in FIG. 4A, the magnitude of the impedance for each logarithmically scaled frequency may be drawn to be the DRT information as illustrated in FIG. 4B.

The impedance information which is disclosed in the present disclosure may be impedance information that may be shown in a Nyquist plot. The DRT information which is disclosed in the present disclosure may be a distribution graph in which the impedance information is converted into a distribution for relaxation times.

Hereinafter, each operation will be described in further detail.

To begin with, the server 100 may acquire impedance information on the battery cell 300 by performing the EIS for a subject battery cell 300 including a mixed anode in which a first component and a second component is mixed. Here, such impedance information may be acquired from the battery management device 200. As described above, the battery management device 200 may acquire impedance information on the subject battery cell by performing the EIS for the subject battery cell at a predetermined temperature or more.

Afterward, the server 100 may generate a graph showing a magnitude of impedance according to a frequency by calculating the DRT for the impedance information acquired as such. Then, the server 100 may generate a plurality of graphs showing the magnitude of the impedance according to the frequency while changing a state of charge value of the subject battery cell. The server 100 may calculate respective resistance values of impedance in the graphs and determine that a state of charge in a section in which respective ratios of the resistance values are changed to be a predetermined threshold value or more as being rapidly changed is an active area in which a first component is dominant. In contrast, the server 100 may calculate the resistance values of the impedance and determine that when the respective ratios of the resistance values are not largely changed at predetermined state of charge sections, the states of charge sections are active areas in which a second component is dominant.

The server 100 may acquire impedance change information according to the frequency by performing a Nyquist plot analysis for the identical impedance information while changing a state of charge of the battery cell without performing DRT. The server 100 may acquire a difference between resistance values in a predetermined frequency section at a predetermined state of charge of the battery cell and compare differences of resistance values in a predetermined frequency section at a plurality of states of charge of the battery cell. When a change in the above-described difference between the resistance values at the predetermined state of charge is significant as a result of comparison, the server 100 may determine that a corresponding charging section is the active area in which the first component is dominant.

FIG. 5 is a diagram for describing a DRT information analysis process in a method for inspecting an active area of a battery cell according to an example embodiment.

Referring to FIG. 5, the server 100 according to an example embodiment may generate, according to a change in a state of charge value of a subject battery cell, graphs showing a magnitude of impedance according to a frequency and inspect an active area of the subject battery cell based on a first resistance value of impedance in a first graph at a first state of charge value, a second resistance value of impedance in a second graph at a second state of charge value less than the first state of charge value, and a third resistance value of impedance in a third graph at a third state of charge value less than the second state of charge value. In this case, the change in the state of charge value of the subject battery cell may be, for example, a change in which the state of charge value is constantly decreased or increased between 0% and 100%. For example, under an assumption that the server 100 generates, according to a change in which the state of charge value of the subject battery cell is constantly decreased, the graph according to the frequency, the server 100 may generate a first graph 520-1 showing a magnitude of impedance according to a change in a frequency value from a first frequency value 510-1 (e.g., $10^5$ Hertz (Hz)) to a second frequency value 510-2 (e.g., $10^2$ Hertz (Hz)) at the first state of charge value and a second graph 520-2 showing a magnitude of impedance according to a change in the frequency value from the first frequency value 510-1 to the second frequency value 510-2 at the second state of charge value less than the first state of charge value. In addition, the server 100 may generate a third graph 520-3 showing a magnitude of impedance according to a change in the frequency value from the first frequency value 510-1 to the second frequency value 510-2 at the third state of charge value less than the second state of charge value.

The server 100 according to an example embodiment may inspect the active area of the subject battery cell based on a first resistance value of the impedance in the first graph 520-1 at the first state of charge value, a second resistance value of the impedance in the second graph 520-2 at the second state of charge value less than the first state of charge value, and a third resistance value of the impedance in the third graph 520-3 at the third state of charge value less than the second state of charge value. In this case, the first resistance value may be acquired based on a value 530-1 obtained by integrating the first graph 520-1 according to the frequency. The second resistance value may be acquired based on a value 530-2 obtained by integrating the second graph 520-2 according to the frequency. The third resistance value may be acquired based on a value 530-3 obtained by integrating the third graph 520-3 according to the frequency.

The server 100 may calculate a first ratio of the first resistance value to the second resistance value and calculate a second ratio of the second resistance value to the third resistance value. Also, the server 100 may calculate a third ratio that is a ratio of the second ratio to the first ratio. Furthermore, the server 100 may determine that an active area in which a first component of a mixed anode is dominant is a first state of charge when the third ratio is less than or equal to a predetermined threshold value (e.g., 2). For example, the server 100 may calculate the first ratio, the second ratio, and the third ratio according to the following Equation 1.

[Equation 1]

$$r_1 = \frac{R_1}{R_2}$$

$$r_2 = \frac{R_2}{R_3}$$

$$r_3 = \frac{r_2}{r_1}$$

In this case, $R_1$ to $R_3$ may denote the first resistance value to the third resistance value, respectively. $r_1$ to $r_3$ may denote the first ratio to the third ratio, respectively. As illustrated in FIG. 5, as identifiable through a comparison between respective areas of the value 530-3 obtained by integrating the third graph 520-3 according to the frequency and the value 530-2 obtained by integrating the second graph 520-2 according to the frequency, a difference between the third resistance value and the second resistance value is not large, and thus, the second ratio in this case may be regarded as being close to approximately 1. However, when respective areas of the value 530-2 obtained by integrating the second graph 520-2 according to the frequency and the value 530-1 obtained by integrating the first graph 520-1 according to the frequency are compared, the first resistance value may be identified as having a magnitude that is approximately a half of the second resistance value, and thus, the first ratio in this case may be regarded as being close to approximately 0.5. Accordingly, the third ratio which is the ratio of the second ratio to the first ratio may be close to approximately a value greater than or equal to 2 that is the predetermined threshold value. In other words, while generating, according to the change in which the state of charge value of the subject battery cell is constantly decreased, the first graph 520-1, the second graph 520-2, and the third graph 520-3 according to the frequency, the server 100 may compare the first resistance value to the third resistance value based on values obtained by individually integrating the graphs according to the frequency. When the first ratio which is the ratio of the first resistance value to the second resistance value shows a significant difference in values when compared to the second ratio which is the ratio of the second resistance value to the third resistance value, the third ratio may have the value greater than or equal to the predetermined value (e.g., 1.5), and the server 100 may determine that the first resistance value at the first state of charge has changed further rapidly than the third resistance value at the third state of charge and the second resistance value at the second state of charge. Accordingly, the server 100 may determine that the active area in which the first component of the mixed anode is dominant is the first state of charge.

Even when a state of charge value is not equal to the above-described first state of charge value to third state of charge value, the server 100 may generate the first graph 520-1 to the third graph 520-3, which are described above in FIG. 5, according to a random change in the state of charge value. Also, similarly to the above description, the server 100 may calculate the first ratio, the second ratio, and the third ratio based on the first resistance value, the second resistance value, and the third resistance value. When the third ratio is less than the predetermined threshold value unlike description with reference to FIG. 5, the server 100 may determine that the first resistance value at the first state of charge value has not been greatly changed similarly to the third resistance value at the third state of charge or the second resistance value at the second state of charge value. In this case, the third ratio may have a value less than the predetermined threshold value, and the server 100 may determine that an active area in which the second component of the mixed anode is dominant is the first state of charge, the second state of charge, and the third state of charge.

FIG. 6 is a diagram for describing a Nyquist plot analysis process in a method for inspecting an active area of a battery cell according to an example embodiment.

Referring to FIG. 6, the server 100 according to an example embodiment may acquire impedance change information according to a frequency by performing a Nyquist plot analysis for the impedance information described above in FIGS. 2 and 4A. In this case, the plot analysis may be performed for at least one section of frequency sections selected based on a user input or frequency sections randomly selected by the server. For example, the server 100 may acquire pieces of impedance change information 620-1, 620-2, and 620-3 depending on a battery state of charge value in a frequency section selected based on the user input (e.g., a frequency section from $10^5$ Hz to $10^2$ Hz). With the first frequency value 510-1 and the second frequency value 510-2 as references, which are described in FIG. 5, the server 100 may determine that a battery state of charge at a time at which a difference between a resistance value at the first frequency value 510-1 and a resistance value at the second frequency value 510-2 is rapidly changed in each change information is a state of charge corresponding to an active area in which a first component is dominant.

For example, the server 100 may acquire a difference 650-1 between a resistance value 630-1 at the first frequency value 510-1 and a resistance value 640-1 at the second frequency value 510-2 in impedance change information 620-1 at a first state of charge value. In addition, the server 100 may acquire a difference 650-2 between a resistance value 630-2 at the first frequency value 510-1 and a resistance value 640-2 at the second frequency value 510-2 in impedance change information 620-2 at a second state of charge value less than the first state of charge value and a difference 650-3 between a resistance value 630-3 at the first frequency value 510-1 and a resistance value 640-3 at the second frequency value 510-2 in impedance change information 620-3 at a third state of charge value less than a second state of charge value.

When the difference 650-1 at the first state of charge value is determined as being larger than the difference 650-2 at the second state of charge and the difference 650-3 at the third state of charge to be a predetermined value or more with a change in which the battery state of charge value is constantly decreased from the first state of charge value to the third state of charge value as identifiable in FIG. 6, the server 100 may determine, based on an input on active area inspection, which is received from a user terminal (not illustrated), that a first state of charge is the state of charge corresponding to the active area in which the first component of a mixed anode is dominant.

The method for inspecting the active area of the battery cell according to the present disclosure in FIGS. 5 and 6 has been described with, as a reference, the change in which the battery state of charge value is constantly decreased with, as a reference, the first state of charge value, the second state of charge value less than the first state of charge, and the third state of charge value less than the second state of charge value. However, it is apparent that a case of a change in which the battery state of charge value is constantly increased in contrast thereto also corresponds to an example embodiment of the method for inspecting the active area of the battery cell according to the present disclosure.

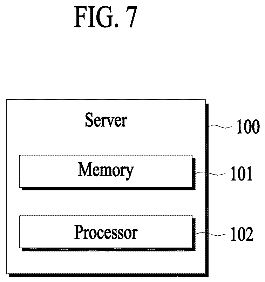

FIG. 7 is a block diagram illustrating a server according to an example embodiment.

According to an example embodiment, the server 100 may include a memory 101 and a processor 102. In the server 100 which is illustrated in FIG. 7, only elements associated with the present example embodiment are illustrated. Thus, those skilled in the art associated with the present example embodiment may understand that other elements in general use in addition to the elements illustrated in FIG. 7 may be further included. In an example embodiment, the processor 102 may be included in a controller.

The processor 102 may control overall operations of the server 100 and process data and a signal. The processor 102 may be formed of at least one hardware unit. In addition, the processor 102 may be operated by one or more software module generated by executing program code stored in the memory 101. Since the processor 102 may include a memory, the processor 102 may control the overall operations of the server 100 and process the data and the signal by executing program code stored in the memory.

The processor 102 may be set to acquire impedance information on a battery cell by performing electrochemical impedance spectroscopy for a subject battery cell that is a subject of inspection, acquire impedance change information according to a frequency based on the impedance information, and inspect an active area of the subject battery cell based on the impedance change information.

Depending on example embodiments, the server 100 may additionally include a transceiver for performing wired/wireless communication. The server 100 may communicate with an external electronic device (e.g., the battery management device 200) by using the transceiver. The external electronic device may be a terminal or a server. Also, a communication technology used by the transceiver may include Global System for Mobile communication (GSM), Code Division Multi Access (CDMA), Long Term Evolution (LTE), 5th Generation, (5G), a wireless local area network (WLAN), Wireless-Fidelity (Wi-Fi), Bluetooth, radio frequency identification (RFID), infrared data association (IrDA), ZigBee, near field communication (NFC), or the like.

The server according to the above-described example embodiments may include a processor, a memory that stores and executes program data, a permanent storage such as a disk drive, a communication port for communicating with an external device, and a user interface device such as a touch panel, a key, and an button. Methods implemented by software modules or algorithms may be stored in a computer-readable recording medium as computer-readable code or program instructions executable in the processor. Here, the computer-readable recording medium may include a magnetic storage medium (e.g., a read-only memory (ROM), a random-access memory (RAM), a floppy disk, a hard disk, or the like), an optical reading medium (e.g., a CD-ROM or a digital versatile disc (DVD)), or the like. The computer-readable recording medium may be dispersed to computer systems connected by a network so that computer-readable codes may be stored and executed in a dispersed manner. The medium may be read by a computer, stored in the memory, and executed by the processor.

The present example embodiments may be represented by functional blocks and various processing steps. These functional blocks may be implemented by various numbers of hardware and/or software configurations that execute specific functions. For example, the present example embodiments may adopt integrated circuit configurations such as a memory, a processor, a logic circuit, and a look-up table that may execute various functions by control of one or more microprocessors or other control devices. Similarly to that elements may be executed by software programming or software elements, the present example embodiments may be implemented by programming or scripting languages such as C, C++, Java, and assembler language, including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing, for example. The terms "mechanism", "element", "means", and "configuration" may be widely used and are not limited to mechanical and physical components. These terms may include meaning of a series of routines of software in association with a processor.

The above-described embodiments are merely examples and other embodiments may be implemented within the scope of the following claims.

## Claims

1. A method for inspecting an active area of a battery cell including a mixed anode in which a first component and a second component are mixed, the method performed in a server and comprising:

   acquiring impedance information on the battery cell by performing electrochemical impedance spectroscopy for a subject battery cell that is a subject of inspection;
   acquiring impedance change information according to a frequency based on the impedance information; and
   inspecting an active area of the subject battery cell based on the impedance change information.

2. The method of claim 1, wherein the acquiring of the impedance change

   information comprises generating a graph showing a magnitude of impedance according to the frequency by performing distribution of relaxation times (DRT) for the impedance information, and
   the inspecting comprises inspecting an active area of the mixed anode based on the graph.

3. The method of claim 2, wherein the generating of the graph comprises

   generating, according to a change in a state of charge (SoC) value of the subject battery cell, graphs showing the magnitude of the impedance according to the frequency, and
   the inspecting comprises inspecting the active area of the subject battery cell based on:

      a first resistance value of impedance in a first graph at a first state of charge value;
      a second resistance value of impedance in a second graph at a second state of charge value less than the first state of charge value; and
   a third resistance value of impedance in a third graph at a third state of charge value less than the second state of charge value.

4. The method of claim 3, wherein the inspecting comprises:

   calculating a first ratio of the first resistance value to the second resistance value;
   calculating a second ratio of the second resistance value to the third resistance value;
   calculating a third ratio that is a ratio of the second ratio to the first ratio; and
   determining that an active area in which the first component of the mixed anode is dominant is a first state of charge when the third ratio is less than or equal to a predetermined threshold value.

5. The method of claim 3, wherein the inspecting comprises:

   calculating a first ratio of the first resistance value to the second resistance value;
   calculating a second ratio of the second resistance value to the third resistance value;
   calculating a third ratio that is a ratio of the second ratio to the first ratio; and
   determining that an active area in which the second component of the mixed anode is dominant is a first state of charge, a second state of charge, and a third state of charge when the third ratio is less than a predetermined threshold value.

6. The method of claim 3, wherein the first resistance value is acquired

   based on a value obtained by integrating the first graph according to the frequency,
   the second resistance value is acquired based on a value obtained by integrating the second graph according to the frequency, and
   the third resistance value is acquired based on a value obtained by integrating the third graph according to the frequency.

7. The method of claim 1, wherein the acquiring of the impedance change information according to the frequency comprises acquiring the impedance change information according to the frequency by performing a Nyquist plot analysis for the impedance information, and the Nyquist plot analysis is performed for at least one section of frequency sections selected based on a user input or frequency sections randomly selected.

8. The method of claim 1, wherein the first component is an SiO component, and
the second component is a graphite component.

9. The method of claim 1, wherein the acquiring comprises acquiring impedance information on the subject battery cell by performing the electrochemical impedance spectroscopy for the subject battery cell at a predetermined temperature or more.

10. A non-transitory computer-readable recording medium in which a program for executing the method of any one of claims 1 through 9 in a server is recorded.

11. A sever comprising:

a memory configured to store an instruction; and
a processor connected to the memory,
wherein the processor is configured to:

acquire impedance information on the battery cell by performing electrochemical impedance spectroscopy for a subject battery cell that is a subject of inspection;
acquire impedance change information according to a frequency based on the impedance information; and
inspect an active area of the subject battery cell based on the impedance change information.

# FIG. 1

100

200

300

| Server | ↔ | Battery management device | ↔ | Battery cell |

FIG. 2

# FIG. 3

Start

Acquire impedance information on battery cell by performing electrochemical impedance spectroscopy for subject battery cell that is subject of inspection ~310

Acquire impedance change information according to frequency based on impedance information ~320

Inspect active area of subject battery cell based on impedance change information. ~330

End

# FIG. 4A

FIG. 4B

FIG. 5

FIG. 6

FIG. 7

Server ~ 100

Memory ~ 101

Processor ~ 102

## INTERNATIONAL SEARCH REPORT

| International application No. |
|---|
| **PCT/KR2024/011719** |

### A. CLASSIFICATION OF SUBJECT MATTER

**G01R 31/389**(2019.01)i; **G01R 31/396**(2019.01)i; **G01R 31/382**(2019.01)i; **G01R 31/367**(2019.01)i; **G01R 27/08**(2006.01)i; **G01R 23/16**(2006.01)i; **H01M 4/36**(2006.01)i

According to International Patent Classification (IPC) or to both national classification and IPC

### B. FIELDS SEARCHED

Minimum documentation searched (classification system followed by classification symbols)

G01R 31/389(2019.01); B60L 58/16(2019.01); G01R 31/36(2006.01); G01R 31/392(2019.01); H01M 10/04(2006.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 전기화학 임피던스 분광법(Electrochemical Impedance Spectroscopy), 활성 영역 (active region), 완화 시간 분포(Distribution of Relaxation Times), 충전 상태 값(State of Charge)

### C. DOCUMENTS CONSIDERED TO BE RELEVANT

| Category* | Citation of document, with indication, where appropriate, of the relevant passages | Relevant to claim No. |
|---|---|---|
| A | JP 2012-079582 A (NEC CORP.) 19 April 2012 (2012-04-19)<br>See paragraphs [0001] and [0025]-[0052] and figure 3. | 1-11 |
| A | KR 10-2022-0048371 A (LG ENERGY SOLUTION, LTD.) 19 April 2022 (2022-04-19)<br>See paragraphs [0042], [0060] and [0102]. | 1-11 |
| A | KR 10-2581184 B1 (MINTECH CO., LTD.) 21 September 2023 (2023-09-21)<br>See claim 1 and figure 2. | 1-11 |
| A | KR 10-2022-0093842 A (LG ENERGY SOLUTION, LTD.) 05 July 2022 (2022-07-05)<br>See paragraphs [0097]-[0111] and figure 5. | 1-11 |
| A | KR 10-2022-0043070 A (ADVANCED MEASUREMENT TECHNOLOGY, INC.) 05 April 2022 (2022-04-05)<br>See claim 1 and figure 1. | 1-11 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **04 November 2024** | **05 November 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/011719**

| Patent document cited in search report | | | Publication date (day/month/year) | Patent family member(s) | | | Publication date (day/month/year) |
|---|---|---|---|---|---|---|---|
| JP | 2012-079582 | A | 19 April 2012 | None | | | |
| KR | 10-2022-0048371 | A | 19 April 2022 | CN | 115428230 | A | 02 December 2022 |
| | | | | EP | 4131573 | A1 | 08 February 2023 |
| | | | | EP | 4131573 | A4 | 06 December 2023 |
| | | | | EP | 4131573 | B1 | 25 September 2024 |
| | | | | JP | 2023-517587 | A | 26 April 2023 |
| | | | | JP | 7404612 | B2 | 26 December 2023 |
| | | | | US | 11929472 | B2 | 12 March 2024 |
| | | | | US | 2023-0198038 | A1 | 22 June 2023 |
| | | | | WO | 2022-080837 | A1 | 21 April 2022 |
| KR | 10-2581184 | B1 | 21 September 2023 | None | | | |
| KR | 10-2022-0093842 | A | 05 July 2022 | CN | 115917340 | A | 04 April 2023 |
| | | | | EP | 4163655 | A1 | 12 April 2023 |
| | | | | EP | 4163655 | A4 | 10 January 2024 |
| | | | | JP | 2023-515840 | A | 14 April 2023 |
| | | | | JP | 7392248 | B2 | 06 December 2023 |
| | | | | KR | 10-2657496 | B1 | 12 April 2024 |
| | | | | US | 12092681 | B2 | 17 September 2024 |
| | | | | US | 2023-0168292 | A1 | 01 June 2023 |
| | | | | WO | 2022-145822 | A1 | 07 July 2022 |
| KR | 10-2022-0043070 | A | 05 April 2022 | CA | 3136621 | A1 | 15 October 2020 |
| | | | | CN | 114174846 | A | 11 March 2022 |
| | | | | CN | 114174846 | B | 03 October 2023 |
| | | | | EP | 3953718 | A1 | 16 February 2022 |
| | | | | EP | 3953718 | A4 | 11 January 2023 |
| | | | | EP | 3953718 | B1 | 05 June 2024 |
| | | | | JP | 2022-526030 | A | 20 May 2022 |
| | | | | US | 11262412 | B2 | 01 March 2022 |
| | | | | US | 2020-0386820 | A1 | 10 December 2020 |
| | | | | WO | 2020-210788 | A1 | 15 October 2020 |

Form PCT/ISA/210 (patent family annex) (July 2022)